# EUROPEAN PATENT APPLICATION

(11) **EP 4 801 229 A2**
(43) Date of publication of application: **02.09.2026**
(21) Application number: 26190963.4
(22) Date of filing: 20.11.2024
(51) Int. Cl.: H10H 20/857

(54) **LIGHT EMITTING DEVICE AND LIGHT EMITTING MODULE INCLUDING THE SAME**

(30) Priority: 20.11.2023 US 202363600860 P; 19.11.2024 US 202418952084
(62) Document number(s) of the earlier application(s) in accordance with Art. 76 EPC: 24894610.5 / 4 797 916
(71) Applicant: Seoul Viosys Co., Ltd., Ansan-si, Gyeonggi-do 15429 (KR)
(72) Inventor: CHOI, Hyo Shik, 15429 Ansan-Si, Gyeonggi-do (KR)
(74) Representative: Isarpatent

(57) **Abstract**

A light emitting device includes a semiconductor layer, an insulation layer, a first electrode, and a second electrode. The semiconductor layer may include a first window layer doped with a first dopant, a second window layer doped with a second dopant, and an active layer disposed between the first window layer and the second window layer. The insulation layer may cover the semiconductor layer and may include an opening exposing a region of at least a window layer of the first window layer or the second window layer. The first electrode may be electrically connected to the first window layer. The second electrode may be electrically connected to the second window layer. The first window layer may protrude in a direction in which the first electrode is disposed and may include an electrode placement region in which the first electrode is disposed. At least a region of the electrode placement region may have an acute angle defined between upper and side surfaces thereof.

## Description

### [Technical Field]

The present invention relates to a light emitting device and a light emitting module comprising the same.

### [Background Art]

A light emitting diode (LED) is a type of light emitting device that emits light when electric current is applied thereto. A light emitting diode is formed by growing epitaxial layers on a substrate and includes an N-type semiconductor layer, a P-type semiconductor layer, and an active layer interposed therebetween. An N-electrode pad is formed on the N-type semiconductor layer and a P-electrode pad is formed on the P-type semiconductor layer such that the light emitting diode is electrically connected to an external power source through the electrode pads in operation. Here, electric current flows from the P-electrode pad to the N-electrode pad through the semiconductor layers.

In order to prevent light loss due to the P-electrode pad while improving heat dispersion efficiency, flip-chip type light emitting diodes are used and various electrode structures are proposed to assist in current dispersion in large flip-chip light emitting diodes. For example, a reflective electrode is formed on the P-type semiconductor layer and extensions for current dispersion are formed in an exposed region of the N-type semiconductor layer formed by etching the P-type semiconductor layer and the active layer.

A display apparatus employing the light emitting diodes may be obtained by forming structures of red (R), green (G), and blue (B) light emitting diodes (LEDs) individually grown on a final substrate.

### [Disclosure]

### [Technical Problem]

Embodiments of the present invention provide a light emitting device capable of improving light extraction efficiency.

Embodiments of the present invention provide a light emitting device capable of focusing light emitted therefrom in an upward direction thereof.

Embodiments of the present invention provide a light emitting device allowing uniform distribution of electric current over a surface thereof.

Embodiments of the present invention provide a light emitting device capable of preventing electrode delamination.

Embodiments of the present invention provide a light emitting device that maximizes an area for electrode placement.

### [Technical Solution]

In accordance with one aspect of the present invention, there is provided a light emitting device including a semiconductor layer, an insulation layer, a first electrode, and a second electrode. The semiconductor layer may include a first window layer doped with a first dopant, a second window layer doped with a second dopant, and an active layer disposed between the first window layer and the second window layer. The insulation layer may cover the semiconductor layer and may include an opening exposing a region at least a window layer of the first window layer or the second window layer. The first electrode may be electrically connected to the first window layer. The second electrode may be electrically connected to the second window layer. The first window layer may protrude in a direction in which the first electrode is disposed and may include an electrode placement region in which the first electrode is disposed. At least a region of the electrode placement region may have an acute angle defined between upper and side surfaces thereof.

The semiconductor layer may include a mesa. The mesa may have a structure that gradually decreases and then increases again in width or cross-sectional area in an upward direction.

An upper surface of the semiconductor layer may have a smaller cross-sectional area or width than a lower surface of the semiconductor layer. In addition, the semiconductor layer may include a protruding region formed on the upper surface thereof and protruding outwards beyond a side surface of the mesa.

At least a region of the electrode placement region may have a greater width in an upper region thereof than in a lower region thereof.

At least a side surface of the electrode placement region may have the same inclination direction as an inner side surface of the insulation layer. The inner side surface of the insulation layer may include a region adjacent to the inner side surface of the electrode placement region among inner side surfaces of the insulation layer defining the opening on the electrode placement region.

The light emitting device may further include a first ohmic electrode disposed between the first electrode and the first window layer.

The first ohmic electrode may include a first region and a second region having different coefficients of thermal expansion. Here, the first region may have a coefficient of thermal expansion between a coefficient of thermal expansion of the first electrode and a coefficient of thermal expansion of the second region.

The light emitting device may further include side irregularities formed on a side surface between an upper surface of the first window layer and a lower surface of the second window layer.

In accordance with another aspect of the present invention, there is provided a light emitting device including a semiconductor layer, an insulation layer, a first electrode, and a second electrode. The semiconductor layer may include a first window layer doped with a first dopant, a second window layer doped with a second dopant, and an active layer disposed between the first window layer and the second window layer. The insulation layer may cover the semiconductor layer and may include an opening exposing a region of at least a window layer of the first window layer or the second window layer. The first electrode may be electrically connected to the first window layer. The second electrode may be electrically connected to the second window layer. A side surface of the active layer may be located more inwardly than an outermost side surface of the first window layer.

The semiconductor layer may include a mesa including an upper surface having a smaller cross-sectional area or width than a lower surface of the semiconductor layer. The mesa may gradually decrease and then increase in width or cross-sectional area in an upward direction.

The first window layer may include an electrode placement region in which the first electrode is disposed. Here, the electrode placement region may protrude farther than other regions of the first window layer in a direction in which the first electrode is disposed.

At least a region of the electrode placement region may have a greater width in an upper region thereof than in a lower region thereof.

At least a region of the electrode placement region may have at least an acute angle defined between upper and side surfaces thereof.

The light emitting device may further include a first ohmic electrode disposed between the first electrode and the first window layer, and including a first region and a second region having different coefficients of thermal expansion. The first region may have a coefficient of thermal expansion between a coefficient of thermal expansion of the first electrode and a coefficient of thermal expansion of the second region.

The light emitting device may further include side irregularities formed on a side surface between an upper surface of the first window layer and a lower surface of the second window layer.

In accordance with a further aspect of the present invention, there is provided a light emitting device including a semiconductor layer, an insulation layer, a first electrode, and a second electrode. The semiconductor layer may include a first window layer doped with a first dopant, a second window layer doped with a second dopant, and an active layer disposed between the first window layer and the second window layer. The insulation layer may cover the semiconductor layer and may include an opening exposing a region of at least a window layer of the first window layer or the second window layer. The first electrode may be electrically connected to the first window layer. The second electrode may be electrically connected to the second window layer. The semiconductor layer may include side irregularities formed on a side surface between an upper surface of the first window layer and a lower surface of the second window layer.

The side irregularities may be formed on a side surface of the active layer.

The semiconductor layer may include a mesa having a structure that gradually decreases and then increases again in width or cross-sectional area in an upward direction. An upper surface of the semiconductor layer may have a smaller cross-sectional area or width than a lower surface of the semiconductor layer and the semiconductor layer may include a protruding region formed on the upper surface thereof and protruding outwards beyond a side surface of the mesa.

The first window layer may protrude in a direction in which the first electrode is disposed and may include an electrode placement region in which the first electrode is disposed. Here, at least a region of the electrode placement region may have a greater width in an upper region thereof than in a lower region thereof.

The light emitting device may further include a first ohmic electrode disposed between the first electrode and the first window layer, and including a first region and a second region having different coefficients of thermal expansion. The first region may have a coefficient of thermal expansion between a coefficient of thermal expansion of the first electrode and a coefficient of thermal expansion of the second region.

### [Advantageous Effects]

The light emitting device according to an embodiment of the present invention allows texturing on a lower surface of a first window layer, thereby improving luminous efficacy thereof.

The light emitting device according to an embodiment of the present invention includes irregularities formed in at least a region on an upper surface of a semiconductor layer, thereby improving light extraction efficiency.

The light emitting device according to an embodiment of the present invention includes irregularities formed in at least a region on a side surface of the semiconductor layer, thereby improving light extraction efficiency.

The light emitting device according to an embodiment of the present invention includes a first window layer, a region of which is located in an upward direction of the second window layer such that light traveling from the first window layer in a downward direction can be reflected from a second window layer or an insulation layer covering the second window layer to be directed in an upward direction of the light emitting device, thereby improving light extraction efficiency.

The light emitting device according to an embodiment of the present invention includes an electrode placement region which has a greater width or a larger cross-sectional area in an upper region than in a lower region, thereby increasing an electrode placement area.

The light emitting device according to an embodiment of the present invention includes an ohmic electrode including an one region and an another region, in which the one region has a coefficient of thermal expansion between a coefficient of thermal expansion of the electrode and a coefficient of thermal expansion of the another region, thereby preventing electrode delamination.

### [Description of Drawings]

The accompanying drawings, which are included to provide a further understanding of the invention and are incorporated in and constitute a part of this specification, illustrate exemplary embodiments of the invention, and together with the description serve to explain the inventive concepts.
FIG. 1 is a schematic cross-sectional view of a light emitting device according to a first embodiment of the present invention.
FIG. 2A and FIG. 2B are composition profiles of the light emitting device according to the first embodiment.
FIG. 3 is a schematic cross-sectional view of a light emitting device according to a second embodiment of the present invention.
FIG. 4 is a schematic cross-sectional view of a light emitting device according to a third embodiment of the present invention.
FIG. 5 is a schematic cross-sectional view of a light emitting device according to a fourth embodiment of the present invention.
FIG. 6 is an enlarged view of a region (B) of the light emitting device of FIG. 6.
FIG. 7 is a schematic cross-sectional view of a light emitting device according to a fifth embodiment of the present invention.
FIG. 8 is a schematic cross-sectional view of a light emitting device according to a sixth embodiment of the present invention.
FIG. 9 is a top view of a light emitting device according to the present invention, illustrating a first embodiment of a first electrode pattern.
FIG. 10 is a top view of the light emitting device according to the present invention, illustrating a second embodiment of the first electrode pattern.
FIG. 11 is a top view of the light emitting device according to the present invention, illustrating a third embodiment of the first electrode pattern.
FIG. 12 is a view of a light emitting apparatus employing a light emitting device according to an embodiment of the present invention.

### [Mode for Invention]

Since the present invention may be modified in various ways and take many different forms, specific embodiments will be illustrated in the drawings and described in detail in the written description. However, this is not intended to limit the present invention to the specific disclosed forms, and it should be understood to include all modifications, equivalents, and substitutes included within the spirit and technical scope of the present invention.

In the drawings, the width, length, thickness, and the like of components may be exaggerated for convenience of illustration. Furthermore, when a component is described as being "above" or "on" another component, this includes not only cases where each part is "directly above" or "directly on" the other part, but also cases where another component is interposed between the components. Expressions such as "below," "above," "left," or "right" are relative expressions used based on the drawings for descriptive purposes and are not intended to limit the present invention thereby. The light-emitting device of the present invention may be mounted in an upside-down state from that shown in the drawings.

Hereinafter, exemplary embodiment of the present invention will be described in more detail with reference to the accompanying drawings.

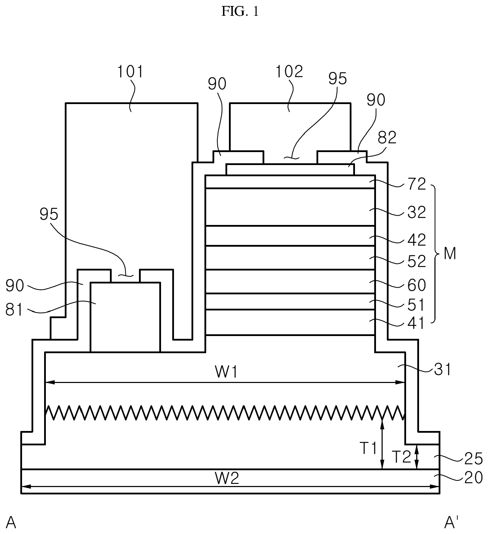

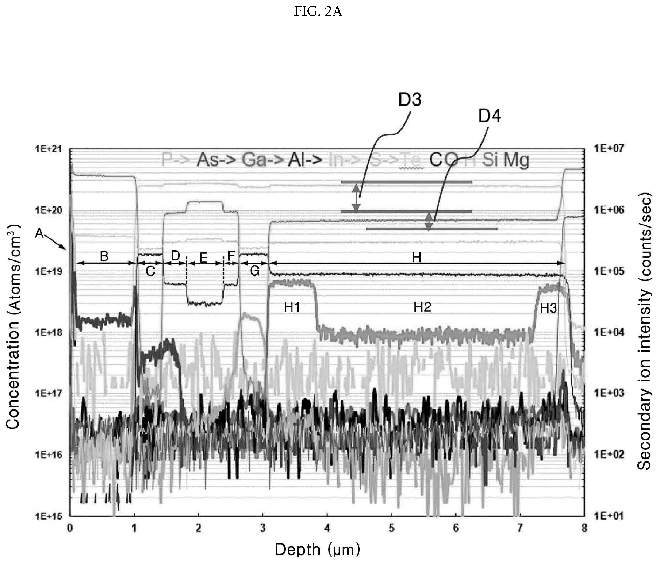

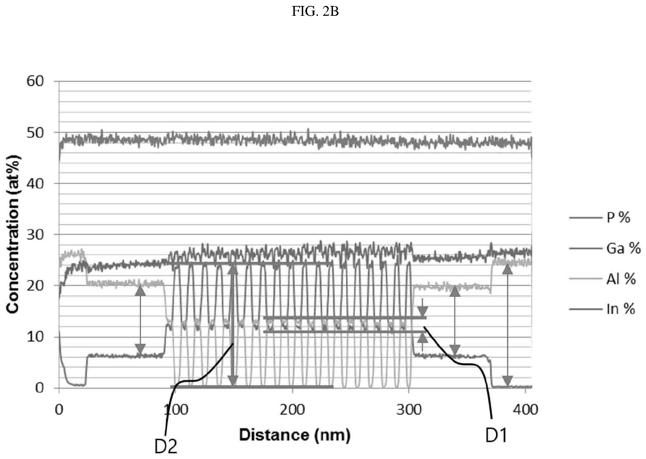

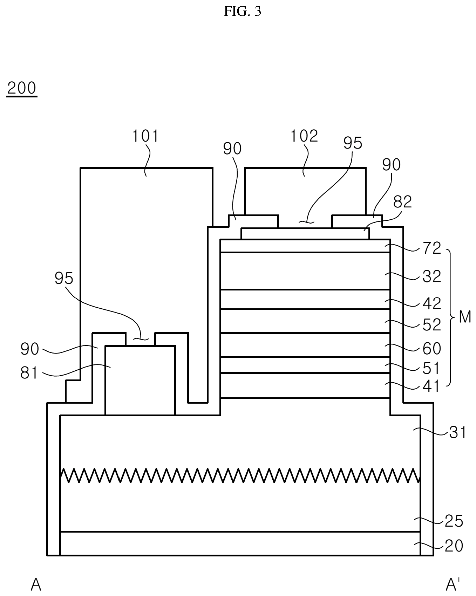

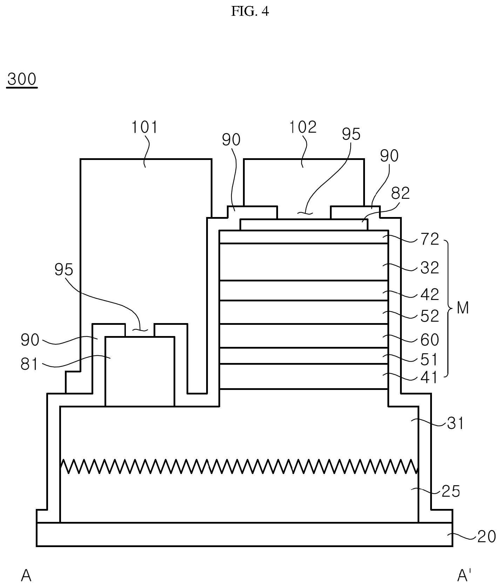

FIG. 1 to FIG. 4 illustrate various embodiments of a light emitting device of the present invention. FIG. 1 is a schematic cross-sectional view of a light emitting device according to a first embodiment of the present invention. FIG. 2A and FIG. 2B are composition profiles of a semiconductor layer of the light emitting device according to the first embodiment. FIG. 3 is a schematic cross-sectional view of a light emitting device according to a second embodiment of the present invention. FIG. 4 is a schematic cross-sectional view of a light emitting device according to a third embodiment of the present invention.

Referring to FIG. 1 to FIG. 4, light emitting devices 100, 200, 300 according to embodiments of the present invention include a first light transmitting layer 20, a first window layer 31 disposed on the first light transmitting layer 20, an active layer 60 disposed on the first window layer 31, a second window layer 32 disposed on the active layer 60, a second ohmic electrode 82 disposed on the second window layer 32, and a first ohmic electrode 81 disposed on the first window layer 31.

In addition, the light emitting devices 100, 200, 300 according to the embodiments of the present invention include at least one of a second light transmitting layer 25 disposed between the first light transmitting layer 20 and the first window layer 31, a first cladding layer 41 and a first electron regulation layer 51 disposed between the first window layer 31 and the active layer 60, a first hole regulation layer 52 and a second cladding layer 42 disposed between the active layer 60 and the second window layer 32, a contact layer 72 disposed between the second window layer 32 and the second ohmic electrode 82, an insulation layer 90 covering an exposed surface of the light emitting device, a first electrode 101 disposed on the first ohmic electrode 81, and a second electrode 102 disposed on the second ohmic electrode 82.

In plan view, the first window layer 31 may have a shape corresponding to a shape of the first light transmitting layer 20, in which each corner is rounded. In addition, the first window layer 31 may have a smaller planar area than the first light transmitting layer 20. According to this embodiment, the first window layer 31 may have rounded corners to prevent current crowding at the corners.

In plan view, a mesa M may have a shape in which at least a region of a side surface or a corner at a side is recessed in a shape corresponding to the shape of the first window layer 31 and each corner is rounded to have a certain radius of curvature. Such a planar shape of the mesa M may effectively disperse light so as not to be concentrated at the corners, thereby improving lateral light emission efficiency of the light emitting devices 100, 200, 300. Furthermore, the mesa M may have a smaller planar area than the first window layer 31. The mesa M may include a light emitting region that substantially contributes to light emission.

In plan view, the second ohmic electrode 82 may have a shape corresponding to the shape of the mesa M, in which a corner at a side is recessed inwardly and each corner is rounded in at least a region thereof. The second ohmic electrode 82 may have a smaller planar area than the mesa M. The second ohmic electrode 82 may be disposed inside an outer periphery of the mesa M. Thus, a separation distance between the second ohmic electrode 82 and the first window layer 31 may be increased to prevent electric short due to migration of a conductive material constituting the second ohmic electrode 82 to the first window layer 31.

The second ohmic electrode 82 may be formed of at least a material of light reflective materials or may be formed of at least a material of light transmissive materials. The light reflective materials may refer to materials exhibiting reflective properties relative to at least some types of light, such as Ge, Al, Cu, Ag, Au, Ni, Cr, Ti, Pt, Rd, Ru, W, Mo, TiW, and the like. The light transmissive materials may refer to materials exhibiting transmissive properties relative to at least some types of light, such as ITO, ZnO, and the like.

The first ohmic electrode 81 may be disposed on the first window layer 31 to be at least partially enclosed in a recess in the planar shape of the mesa M and the second ohmic electrode 82. In plan view, the first ohmic electrode 81 may have a circular shape, an elliptical shape, or a rectangular shape, without being limited thereto.

In plan view, the insulation layer 90 may have a shape corresponding to a shape of the first light transmitting layer 20, in which each corner is rounded. Alternatively, the insulation layer 90 may cover all corners of the first light transmitting layer 20. In addition, a horizontal distance from one end of the insulation layer 90 to the other end thereof may be the same as a distance from one end of the first light transmitting layer 20 to the other end thereof. Further, the insulation layer 90 may have a surface area corresponding to a surface area of the first light transmitting layer 20 in plan view. Alternatively, the insulation layer 90 may cover all side surfaces of the first light transmitting layer 20 connected to the corners thereof. Here, light extraction can be effectively realized even on the side surfaces of the first light transmitting layer 20 and in regions near the side surfaces thereof due to change in index of refraction at the interface between the first light transmitting layer 20 and the insulation layer 90.

An opening 95 may be formed in the insulation layer 90. The insulation layer 90 may have a single opening 95 or a plurality of openings 95. The plurality of openings 95 may have the same shape or at least an opening 95 may have a different shape than the other openings 95. For example, the insulation layer 90 may include four openings 95 in each quadrant thereof. The first and second ohmic electrodes 81, 82 may be electrically connected to the first and second electrodes 101, 102 through the openings 95 formed in the insulation layer 90, respectively.

The insulation layer 90 may be formed of a light transmissive material or a material having oxide film properties. For example, the insulation layer 90 may be formed of a material, such as SiO₂, TiO₂, AlO_{X}, or NiO_{X}.

The light emitting devices 100, 200, 300 may include a plurality of electrodes 101, 102. Specifically, the light emitting devices 100, 200, 300 may include a first electrode 101 connected to the first ohmic electrode 81 and a second electrode 102 connected to the second ohmic electrode 82.

In plan view, the first electrode 101 may have a shape in which one corner has a smaller curvature than the other corners and the second electrode 102 may have a square or rectangular shape, without being limited thereto. Furthermore, the first electrode 101 and the second electrode 102 may be rounded at each corner when viewed in plan view. The electrodes can expand or contract due to heat generation and heat dispersion during operation of the light emitting device. As a result, the electrodes can suffer from delamination at the corners. However, in the light emitting devices 100, 200, 300 according to the embodiments, the electrodes 101, 102 are formed to have the rounded corners to relieve thermal stress concentrated at the corners due to heat generation and heat dispersion, thereby preventing delamination of the electrodes 101, 102.

FIG. 2A and FIG. 2B are graphs depicting the composition of each layer in the light emitting device 100 according to the first embodiment shown in FIG. **1****,** which includes the first window layer 31, the first cladding layer 41, the first electron regulation layer 51, an active layer 60, the first hole regulation layer 52, the second cladding layer 42, the second window layer 32, and the contact layer 72. It should be noted that sections A to H shown in FIG. 2A are approximate for illustration and do not clearly depict the boundary of each layer.

In FIG. 2A, section A (representing a peak in black (Mg) and yellow (H) charts) corresponds to the contact layer 72, section B corresponds to the second window layer 32, section C corresponds to the second cladding layer 42, section D corresponds to the first hole regulation layer 52, section E corresponds to the active layer 60, section F corresponds to the first electron regulation layer 51, section G corresponds to the first cladding layer 41, and section H corresponds to the first window layer 31.

Hereinafter, the light emitting device according to the present invention will be described in detail.

The first light transmitting layer 20 transmits light emitted from the active layer 60 and may be formed of a light transmissive insulating material. As used herein, "light transmissive" includes not only a transparent material that transmits the entirety of light, but also a translucent or partially transparent material that transmits the entirety of light having a predetermined wavelength or only some fractions of the light having a predetermined wavelength. Hereinafter, the same definition is applied.

The first light transmitting layer 20 may be a substrate and may include any one of, for example, a sapphire substrate, a silicon substrate, and a gallium nitride substrate.

The first window layer 31 serves to generate and supply electrons. The dopant used to form the first window layer 31 is an n-type dopant, for example, Si or Te.

In the light emitting device 100 according to the first embodiment shown in FIG. **1****,** the first window layer 31 includes a first doping layer. The first doping layer refers to a layer with a higher doping level than other regions of the first window layer 31 and is exposed in a process of etching the mesa M to be electrically connected to the first ohmic electrode 81. Hereinafter, a region of the first window layer 31 having a lower doping level than the first doping layer will be referred to as "second doping layer". In FIG. 2A, section H1 corresponds to the first doping layer and section H2 corresponds to the second doping layer.

The thickness of the first window layer 31 may be greater than or equal to 50% of the total thickness of the semiconductor layers of the light emitting device 100. In addition, the thickness of the first window layer 31 may be greater than or equal to 80% of the thickness of a region under the active layer 60 (by way of example, a region including the first electron regulation layer 51, the first cladding layer 41, the first window layer 31, the second light transmitting layer 25, and the first light transmitting layer 20. Hereinafter, the same). Accordingly, it is possible to improve uniformity of light emission of the light emitting device by securing a sufficient area for electrons to diffuse in the region under the active layer 60. By way of example, the light emitting device 100 may have a total thickness of 4,500 nm to 7,600 nm, preferably 6,500 nm to 7,600 nm. The region under the active layer 60 may have a thickness of 3,000 nm to 5,200 nm and the first window layer 31 may have a thickness of 3,000 nm to 5,000 nm.

By forming the first doping layer H1 on the first window layer 31 such that the first doping layer H1 contacts the first ohmic electrode 81, ohmic contact between the first window layer 31 and the first ohmic electrode 81 can be effectively achieved. In addition, the first window layer 31 may be exposed by forming the mesa from the second window layer 31 toward the first window layer 31 for electrical bonding between the first window layer 31 and the first ohmic electrode 81. Thus, the first ohmic electrode 81 and the second ohmic electrode 82 may be arranged to face in the same direction, thereby making it easier to electrically connect the light emitting device 100 to a circuit.

If the first doping layer H1 is too thick or has too high a doping level, supply of electrons becomes large to increase electron leakage, and if the first doping layer H1 is too thin or has too low a doping level, the first doping layer H1 can fail to achieve ohmic contact with the first ohmic electrode 81. Thus, the inventors of the present invention have optimized the doping level and thickness of the first doping layer H1 through a number of experiments.

The thickness of the first doping layer H1 may be greater than or equal to about 3% and less than 30% of the thickness of the first window layer 31, greater than or equal to about 5% and less than 30% of the thickness of the region under the active layer 60, and greater than or equal to about 30%, preferably greater than or equal to about 6% and less than 20%, of the total thickness of the light emitting device 100. For example, when the light emitting device 100 has a total thickness of 7,600 nm, the region under the active layer 60 has a thickness of 5,200 nm, and the first window layer 31 has a thickness of 4,500 nm, the first doping layer H1 may have a thickness of 300 nm to 900 nm, preferably 400 nm to 600 nm.

Furthermore, the doping level of the first doping layer H1 may be less than or equal to 10 times, preferably 5 times to 10 times, the doping level of the second doping layer H2. For example, the second doping layer may have an average doping level of about 1e17 to 3e18 (hereinafter, Exponential notation is used) atoms/cm³ and the first doping layer H1 may have an average doping level of 4e18 atoms/cm³ or more. With such a relationship of the doping concentrations, the light emitting device 100 can maintain stable electrical characteristics. However, the light emitting device 100 does not necessarily require the second doping layer H2. Alternatively, the light emitting device 100 may be formed with a thicker first doping layer H1.

The first doping layer H1 may have a profile in which the concentration of the dopant varies and may have a profile in which the concentration of hydrogen varies. Here, in the same section, a deviation of the profile in which the concentration of hydrogen varies may be greater than a deviation of the profile in which the concentration of the dopant varies. Therefore, in a process of transporting the dopant through current injection, the difference in concentration of hydrogen with a large deviation can accelerate pumping of the dopant to facilitate electron implantation.

In the light emitting device according to the first embodiment, the first window layer 31 may further include a third doping layer H3, which has a higher doping level than the second doping layer H2, on a lower surface thereof (in an opposite direction to the first doping layer H1. Hereinafter, the same).

By increasing the doping level of the third doping layer H3, texturing of the first window layer 31 can be performed more efficiently. Furthermore, by increasing the doping level of the third doping layer H3, interfacial bonding between the semiconductor layer and the first light transmitting layer 20 can be effectively achieved due to impurities when the first light transmitting layer 20 is bonded thereto after removal of the growth substrate. Furthermore, a bonding material may be disposed between the semiconductor layer and the first light transmitting layer 20 to achieve effective interfacial bonding. The third doping layer H3 may be omitted from the first window layer 31 or may be removed after formation thereof.

The present invention includes embodiments in which a lower surface of the first window layer 31 is subjected to a texturing process and does not include the third doping layer H3 in the final step, and embodiments in which the first window layer 31 is not subjected to the texturing process and includes the third doping layer H3 in the final step.

The doping level of the third doping layer H3 may be substantially similar to or slightly lower than the doping level of the first doping layer H1. In FIG. 2A, Section H3 corresponds to the third doping layer H3.

In a unit thickness range, the degree of change in the profile of the dopant in the first doping layer H1 may be greater than the degree of change in the profile of the dopant in the second doping layer H2. Here, the unit thickness may be 200 nm and a depth of the first doping layer H1 corresponding to the unit thickness thereof is closer to the active layer 60 than a depth of the second doping layer H2 corresponding to the unit thickness thereof. This structure can reduce occurrence of defects in the semiconductor layer due to change in dopant content, thereby preventing diffusion of the defects to the active layer 60.

The active layer 60 may be a multi-quantum well (MQW) layer formed by alternately stacking quantum well (QW) layers and quantum barrier (QB) layers many times, in which electrons and holes recombine in the quantum well layers to emit light. The active layer 60 may have a thickness of 550 nm to 650 nm.

The quantum well layers and the quantum barrier layers may be composed of layers having different energy band gaps. Each of the well layers is formed as a layer having a composition of either AlInGaP or InGaP and may have a thickness in the range of 3 nm to 7 nm. Each of the barrier layers may be formed of a material having a composition of InₓGa_{y}Al_{z}P. In the relationship between y and z, y+z may have a value satisfying: x*0.8≤y+z≤x*1.2. Alternatively, x+y+z=1. Further, z may have a value in the range of 0.15≤z≤0.4. In addition, the quantum barrier layers may be formed by sequentially growing an InAlGaP layer containing about 40% Al as a capping layer and a main InAlGaP layer containing about 50% to about 90% of Al after growing an InGaP layer as a quantum well layer.

The quantum well layer may be formed to a thickness of about 5 nm or less and the quantum barrier layer may be formed to a thickness of 15 nm or less. In addition, when the active layer 60 has a thickness of 550 nm to 650 nm, the light emitting device may have 10 or more pairs of the quantum well layers and the quantum barrier layers, preferably about 20 to 40 pairs, more preferably about 40 pairs.

Referring to FIG. 2B, at least a layer of the active layer 60 may differ from the other layers thereof in amounts of aluminum and gallium that the corresponding layers contain. The composition difference (second composition difference, D2) between aluminum and gallium in at least a quantum well layer may be greater than the composition difference (first composition difference, D1) between aluminum and gallium in at least a quantum barrier layer. The second composition difference D2 may be more than or equal to 10 times the first composition difference D1. Accordingly, the active layer 60 can effectively confine electrons and holes to improve light emission efficiency.

The second window layer 32 serves to form and supply holes. In addition, the second window layer 32 may include a GaP layer. The dopant used to form the second window layer 32 is a P-type dopant and may include, for example, Mg, C, or a combination thereof. The second window layer 32 may have an average doping level of 1e18 atoms/cm³. The second window layer 32 may have a thickness of 500 nm to 10,000 nm, preferably about 1,000 nm.

The second ohmic electrode 82 is electrically connected to the second window layer 32 to form ohmic contact therewith and may be formed of a metallic material. The second ohmic electrode 82 may also directly contact the second window layer 32 to form ohmic contact therewith. In addition, the contact layer 72 may be formed on an upper surface of the second window layer 32 to form ohmic contact with the second ohmic electrode 82. The second ohmic electrode 82 may be formed of at least a material of light reflective materials or at least a material of light transmissive materials. The light reflective materials may be materials exhibiting reflective properties with respect to at least some types of light, such as Ge, Al, Cu, Ag, Au, Ni, Cr, Ti, Pt, Rd, Ru, W, Mo, TiW, and the like. The light transmissive materials may be materials exhibiting transmissive properties with respect to at least some types of light, such as ITO, ZnO, and the like.

The contact layer 72 may be disposed between the second ohmic electrode 82 and the second window layer 32 to form ohmic contact with the second ohmic electrode 82 and may have a higher doping level than the second window layer 32. For example, when the second window layer 32 has an average doping level of about 1e18 atoms/cm³ or less, the contact layer 72 may have an average doping level of about 1e19 atoms/cm³ or more. The contact layer 72 may include a GaP layer.

Since the contact layer 72 has a high doping concentration, defects are present therein due to the dopants thereof and, as the thickness of the contact layer increases, these defects can cause deterioration in luminous efficacy of the light emitting device 100 through light absorption. Thus, the contact layer 72 may have a thickness of less than 100 nm.

The first ohmic electrode 81 may be electrically connected to the first window layer 31 to form ohmic contact therewith and may be formed of a metallic material. The first ohmic electrode 81 may contact the doping layer of the first window layer 31 to form ohmic contact therewith. The first ohmic electrode 81 may be formed of at least a material of the light-reflective materials or at least a material of the light-transmissive materials. The light reflective materials may refer to materials exhibiting reflective properties with respect to at least some types of light, such as Ge, Al, Cu, Ag, Au, Ni, Cr, Ti, Pt, Rd, Ru, W, Mo, TiW, and the like. The light transmissive materials may refer to materials exhibiting transmissive properties with respect to at least some types of light, such as ITO, ZnO, and the like.

The second light transmitting layer 25 is disposed between the first light transmitting layer 20 and the first window layer 31 to transmit light emitted from the active layer 60 and may be formed of a light transmissive insulating material. The second light transmitting layer 25 serves as a bonding layer to join the first window layer 31 and the first light transmitting layer 20 to each other. The second light transmitting layer 25 may be formed of any material having light transmissive properties, such as silicone, polyimide, polypropylene, benzocyclobutene (BCB), silicon dioxide, and the like. The second light transmitting layer 25 may have a different index of refraction than the first window layer 31 and the first light transmitting layer 20. Due to the interfaces having different indexes of refraction, refraction of light can occur effectively, thereby improving light extraction of the light emitting device 100.

The first cladding layer 41 is disposed between the first window layer 31 and the active layer 60 to act as a barrier layer that prevents holes from crossing over to the first window layer 31 and has a relatively high energy bandgap for this purpose.

A dopant for the first cladding layer 41 may belong to a different group than the dopant in the first window layer 31 and may have a larger atomic radius than the dopant in the first window layer 31.

The dopant of the first cladding layer 41 is an n-type dopant and may include, for example, Si, B, P, As, Sb, or Te. Since Te has a larger atomic radius than Si, Te can provide advantages, such as a higher breakdown voltage (VR), better photometric properties, and more definite formation of an n-type layer with a lower concentration than Si when used as a dopant.

The first cladding layer 41 may have a lower dopant concentration than the first doping layer. When the first window layer 31 includes a second doping layer, the dopant concentration of the first cladding layer 41 may be between the dopant concentration of the first doping layer and the dopant concentration of the second doping layer. Furthermore, a difference D3 in dopant concentration between the first cladding layer 41 and the first doping layer may be greater than a difference D4 in dopant concentration between the first cladding layer 41 and the second doping layer. However, it should be understood that the present invention is not limited thereto and the dopant of the first cladding layer 41 and the dopant in the first window layer 31 may be of the same type so as to have the same dopant size.

The first cladding layer 41 may be an n-InₓAl₍₁₋ₓ₎P layer, where x may have a value in the range of 0.4≤x≤0.6. The first cladding layer 41 may have a thickness of about 300 nm to about 450 nm and an average doping level of about 5e17 to 1e18 atoms/cm³.

The first electron regulation layer 51 may be disposed between the first window layer 31 and the active layer 60 to slow the rate at which electrons reach the active layer 60. When the light emitting device 100 according to this embodiment includes both the first cladding layer 41 and the first electron regulation layer 51, the first electron regulation layer 51 may be formed on the first cladding layer 41 (that is, close to the active layer 60). The thickness of the first electron regulation layer 51 may be adjusted to control the rate at which electrons reach the active layer 60.

The first electron regulation layer 51 may be an InₓGa_{y}Al_{z}P layer. In the relationship between y and z, y+z may have a value satisfying: x*0.8 ≤y+z ≤ x*1.2. Alternatively, x+y+z=1. Further, z may have a value in the range of 0.15≤z≤0.4. Such an Al composition can improve light extraction by preventing light emitted from the active layer 60 from being absorbed by the first electron regulation layer 51. The first electron regulation layer 51 may have a lower doping concentration than the first cladding layer 41 and may not include any doping material.

The first electron regulation layer 51 may be formed of the same elements as the first window layer 31 or may have a composition that is free from an element of elements constituting the first window layer 31.

For example, the first window layer 31 may have a combined composition of four elements, in which three elements may be group III elements (B, Al, Ga, In, Tl, or Nh, hereinafter the same) and the remaining element may be an element having a standard atomic weight of 30 or more. The first cladding layer 41 may be a combined composition of three elements, in which two elements may be group III elements and the remaining element may be an element having a standard atomic weight of 30 or more.

In addition, the two group III elements of the first cladding layer 41 may include an element having the largest atomic weight and an element having the smallest atomic weight among the three group III elements of the first window layer 31. Further, the element having a standard atomic weight of 30 or more in the first cladding layer 41 may be the same as the element having a standard atomic weight of 30 or more in the first window layer 31.

By way of example, the first window layer 31 and the first electron regulation layer 51 may be InₓGa_{y}Al_{z}P layers and the first cladding layer 41 may be an n-InₓAl₍₁₋ₓ₎P layer.

A content difference between aluminum and indium contained in the first electron regulation layer 51 may be greater than a content difference between aluminum and indium contained in the barrier layers of the active layer 60. In addition, the content difference between aluminum and indium contained in the first electron regulation layer 51 may be smaller than a content difference between aluminum and indium contained in the well layers of the active layer 60.

The first hole regulation layer 52 may be disposed between the active layer 60 and the second window layer 32 to slow the rate at which holes reach the active layer 60. The thickness of the first hole regulation layer 52 may be adjusted to control the rate at which holes reach the active layer 60.

The first hole regulation layer 52 may include the same group III and group V elements as the first electron regulation layer 51 and may include an InₓGa_{y}Al_{z}P layer. In the relationship between y and z, y+z may have a value satisfying: x*0.8 ≤y+z≤ x*1.2. Alternatively, x+y+z=1. Further, z may have a value in the range of 0.15≤z≤0.4. The first hole regulation layer 52 may have a lower doping concentration than the second cladding layer 42 or may not include any doping material.

A content difference between aluminum and indium contained in the first hole regulation layer 52 may be greater than a content difference between aluminum and indium contained in the barrier layers of the active layer 60. In addition, the content difference between aluminum and indium contained in the first hole regulation layer 52 may be smaller than a content difference between aluminum and indium contained in the well layers of the active layer 60.

The second cladding layer 42 is disposed between the active layer 60 and the second window layer 32 to act as a barrier layer that prevents electrons from crossing over to the second window layer 32 and has a relatively high energy bandgap for this purpose.

The second cladding layer 42 may have a thickness of 500 nm or less, preferably about 300 nm to about 500 nm.

The second cladding layer 42 may have an average doping level of about 8e17 to 1e18 atoms/cm³. A dopant for the second cladding layer 42 is a p-type dopant and may include, for example, Mg, C or a combination thereof. Further, the second cladding layer 42 may include a p-InₓAl₍₁₋ₓ₎P layer, where x may have a value in the range of 0.4≤x≤0.6. The second cladding layer 42 may be formed of two group III elements and may have a higher bandgap energy than layers disposed on top and bottom of the second cladding layer 42. Alternatively, the second cladding layer 42 may have the highest bandgap energy among the semiconductor layers constituting the light emitting device. Thus, the second cladding layer 42 can prevent electrons from crossing over to the second window layer 32.

When the light emitting device 100 includes both the first hole regulation layer 52 and the second cladding layer 42, the first hole regulation layer 52 is formed under the second cladding layer 42 (that is, close to the active layer 60). In addition, the first hole regulation layer 52 may have a greater thickness than the first electron regulation layer 51 to protect the active layer 60 from interdiffusion that occurs during the doping process of the second cladding layer 42. For example, when the first electron regulation layer 51 has a thickness in the range of about 150 nm to about 350 nm, the first hole regulation layer 52 may have a thickness in the range of about 300 nm to about 500 nm. Alternatively, the thickness of the first hole regulation layer 52 may be 1 to 2 times that of the first electron regulation layer 51. Thus, the migration rates of electrons and holes can be balanced by adjusting the thicknesses of the first hole regulation layer 52 and the first electron regulation layer 51.

The light emitting device 100 may further include a light guide layer disposed between the second window layer 32 and the active layer 60, and/or between the active layer 60 and the first window layer 32.

When the light emitting device 100 includes the second cladding layer 42, the first hole regulation layer 52, the first electron regulation layer 51, and the first cladding layer 41, the light guide layer may be formed between the second window layer 32 and the second cladding layer 42 and/or between the first cladding layer 41 and the first window layer 31.

The light guide layer serves to improve luminous efficacy of the light emitting device 100 by increasing reflectivity with respect to light emitted from the active layer 60. The light guide layer may include an InₐAl₍₁₋ₐ₎P layer or an InₓGa_{y}Al_{z}P layer. Here, a may have a value in the range of 0.4≤a≤0.6, and in the relationship between y and z, y+z may have a value satisfying: x*0.8≤y+z≤x*1.2. Alternatively, x+y+z=1. Further, z may have a value in the range of 0.15≤z≤0.4. The light guide layer may be formed as a stack of layers having different energy bandgaps. Alternatively, the light guide layer may be formed as a stack of repeated pairs of layers having different energy bandgaps. The InₐAl₍₁₋ₐ₎P layer may be formed to have an index of refraction 2.9 to 3.0 and the InₓGa_{y}Al_{z}P layer may be formed to have an index of refraction of 3.05 to 3.2. In the light guide layer, a plurality of layers having a refractive index difference of 0.05 to 0.3 may be disposed inside the semiconductor layer to guide light generated in the active layer in a desired direction for extraction. By such a light guide layer, light extraction efficiency of the light emitting device 100 can be improved.

The light guide layer disposed between the active layer 60 and the first window layer 31 can improve light extraction of the light emitting device 100 by rerouting light generated in the active layer 60 and directed toward the first window layer 31 to travel in a direction to the second window layer 32. Here, the light guide layer may have a structure including two layers with different doping concentrations, in which a layer is doped with an n-type dopant. Alternatively, the light guide layer may have a structure including two layers doped with an n-type dopant and having different doping concentrations. Alternatively, the light guide layer may have a structure including two layers doped with an n-type dopant and having the same doping concentrations. With the n-type doped layer, the light guide layer can guide light while facilitating migration of electrons.

The light guide layer disposed between the active layer 60 and the second window layer 32 can improve light extraction of the light emitting device 100 by rerouting light generated in the active layer 60 and directed toward the second window layer 32 to travel toward the first window layer 31. Here, the light guide layer may have a structure including two layers with different doping concentrations, in which a layer is doped with a p-type dopant. Alternatively, the light guide layer may have a structure including two layers doped with a p-type dopant and having different doping concentrations. Alternatively, the light guide layer may have a structure including two layers doped with a p-type dopant and having the same doping concentrations. With the p-type doped layer, the light guide layer can guide light while facilitating migration of holes.

The insulation layer 90 covers most of an exposed surface of the light emitting device and may include SiO₂. The first ohmic electrode 81 and the first electrode 101 may be electrically connected to each other through an opening 95 formed in the insulation layer 90 on an upper surface of the first ohmic electrode 81. In addition, the second ohmic electrode 82 and the second electrode 102 may be electrically connected to each other through the opening 95 in the insulation layer 90 on an upper surface of the second ohmic electrode 82. The first electrode 101 and the second electrode 102 may be formed of a conductive material, such as Ge, Al, Cu, Ag, Au, Ni, Cr, Ti, Pt, Rd, Ru, W, Mo, TiW, and the like.

The second electrode 102 formed on the upper surface of the second ohmic electrode 82 may have an edge disposed inside an edge of the insulation layer 90. In addition, the second electrode 102 may be formed to have the same width as or a narrower width than the second ohmic electrode 82. Alternatively, the second electrode 102 may be formed to have a smaller width than the opening 95 of the insulation layer 90. That is, the second electrode 102 may be formed in an inner region of the opening 95 in the insulation layer 90 to be spaced apart from an inner side surface of the opening 95. With this structure, the second electrode 102 can be prevented from being exposed to moisture infiltrating from the outside of the light emitting device 100.

An edge of the first electrode 101 formed on the upper surface of the first ohmic electrode 81 may extend beyond the edge of the insulation layer 90 to the upper surface of the first window layer 31. In addition, the first electrode 101 may be formed to have a greater width than the first ohmic electrode 81. Alternatively, the first electrode 101 may be formed to have a smaller width than the opening 95 of the insulation layer 90. That is, the first electrode 101 may be formed in the inner region of the opening 95 in the insulation layer 90 to be spaced apart from the inner side surface of the opening 95.

In this embodiment, the first window layer 31 and the first cladding layer 41 may be first conductivity type semiconductor layers, and the second window layer 32 and the contact layer 72 may be second conductivity type semiconductor layers. The first conductivity type and the second conductivity type have opposite polarities to each other. For example, if the first conductivity type is n-type, the second conductivity type is p-type, and if the first conductivity type is p-type, the second conductivity type is n-type.

Although FIG. 1 shows that the side surfaces of the mesa M are formed vertically, the light emitting device according to this embodiment may be formed such that at least a region of the side surface of the mesa M is slanted.

The light emitting module according to this embodiment may have a plurality of light emitting devices mounted in a region of the light emitting module. Preferably, the light emitting devices (preferably the first window layer) occupy an area of 70% or more or in the range of 0.7 times to 1 times an area of the module substrate of the light emitting module. Here, the module substrate may be a circuit board, an insulating substrate, a growth substrate, or the like.

As such, the light emitting module according to this embodiment includes the light emitting devices formed over the entire surface of the light emitting module and thus can be useful when a red-series color light source with high brightness is required in a display apparatus or a brake lamp of a vehicle.

Although not shown in the drawings, the first light transmitting layer 20 may include side irregularities formed along an outer side surface thereof, thereby improving light diffusion efficiency of the light emitting device 100.

Referring to FIG. 1, the first light transmitting layer 20 may have an outer boundary disposed outside an outer boundary of the semiconductor layer disposed on the first light transmitting layer 20. Therefore, since the first light transmitting layer 20 has a larger area than the semiconductor layer and supports the semiconductor layer, it is possible to protect the light emitting device 100 or the semiconductor layer from external force.

Further, since a width W2 of the first light transmitting layer 20 is greater than a width W1 of the semiconductor layer, light emitted from the semiconductor layer can be effectively emitted through the first light transmitting layer 20 even when the semiconductor layer has a wide beam angle.

The second light transmitting layer 25 may include regions having different thicknesses. In the second light transmitting layer 25, a thickness T2 of a region disposed outside an outer boundary of the first window layer 31 and not overlapping the first window layer 31 may be less than a thickness T1 of a region overlapping the first window layer 31. The insulation layer 90 may extend to the region having the thinner thickness T2. Here, since the second light transmitting layer 25 includes the regions with different thicknesses, the second light transmitting layer 25 can have an increased surface area, whereby the path of moisture penetrating into the light emitting device 100 can be increased, thereby increasing the lifespan of the light emitting device 100. The outer boundary of the first window layer 31 may include an inclined side surface.

FIG. 3 is a schematic cross-sectional view of a light emitting device according to a second embodiment of the present invention. Referring to FIG. 3, the outer boundaries of the first window layer 31, the second light transmitting layer 25, and the first light transmitting layer 20 may be formed parallel to each other. With this structure, the light emitting device 100 according to the second embodiment can be miniaturized.

FIG. 4 is a schematic cross-sectional view of a light emitting device according to a third embodiment of the present invention. Referring to FIG. 4, an outer periphery of the first light transmitting layer 20 may be exposed from the second light transmitting layer 25. That is, the first light transmitting layer 20 may be formed to have an outer periphery located outside the outer boundary of the second light transmitting layer 20. In addition, the exposed surface of the first light transmitting layer 20 may be covered with an insulating material. The insulating material may be the same as the insulation layer 90 of the light emitting device 300 or may be a different material than the second light transmitting layer 25. The insulating material may also cover the side surface of the second light transmitting layer 25. In the light emitting device 300 according to the third embodiment, the index of refraction can be changed at the interface between the first light transmitting layer 20 and the insulation layer 90, thereby allowing effective light extraction on the side surface of the first light transmitting layer 20 and near the side surface thereof.

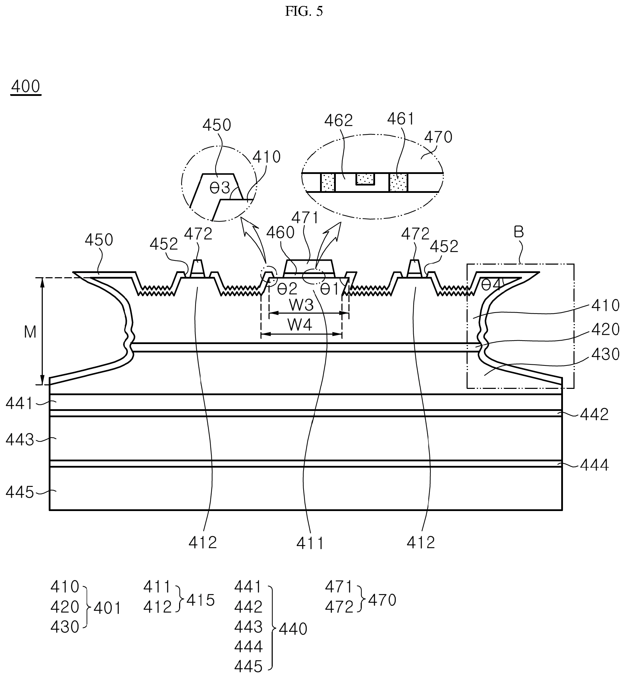

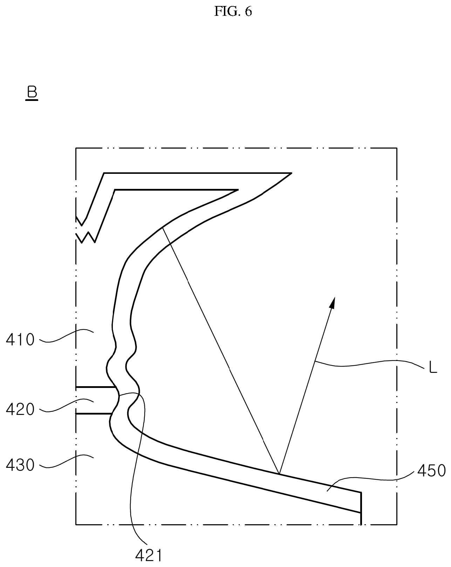

FIG. 5 and FIG. 6 illustrate a light emitting device according to a fourth embodiment of the present invention. FIG. 5 is a schematic cross-sectional view of the light emitting device according to the fourth embodiment of the present invention and FIG. 6 is an enlarged view of a region (B) of the light emitting device according to the fourth embodiment of the present invention.

Referring to FIG. 5, the light emitting device 400 may include a semiconductor layer 401, a first ohmic electrode 460, a first electrode 470, a second electrode 440, and an insulation layer 450.

The semiconductor layer 401 may include a first window layer 410, a second window layer 430, and an active layer 420 disposed between the first window layer 410 and the second window layer 430. For materials for the first window layer 410, the second window layer 430, and the active layer 420 of the semiconductor layer 401 according to this embodiment, refer to the description of the above embodiments. However, the structures of the first ohmic electrode 460, the first electrode 470, the second electrode 440, the semiconductor layer 401, and the insulation layer 450 are different from those of the above embodiments. The following description will focus on different features of the light emitting device 400 shown in FIG. 5 from the above embodiments.

Referring to FIG. 5, the light emitting device 400 has a vertical structure in which the first electrode 470 and the second electrode 440 are disposed in opposite directions from each other. Referring to FIG. 5, a semiconductor layer 401 may be disposed on the second electrode 440, and the insulation layer 450, the first ohmic electrode 460, and the first electrode 470 may be disposed on the semiconductor layer 401. In addition, the semiconductor layer 401 may be disposed on the second electrode 440 in a stack structure in which the second window layer 430, the active layer 420, and the first window layer 410 are sequentially stacked in this order.

The second electrode 440 may include a plurality of conductive layers. For example, the second electrode 440 may include first to fifth conductive layers 441, 442, 443, 444, 445.

The first conductive layer 441 is disposed under the second window layer 430 and may be electrically connected to the second window layer 430 through contact therewith. The first conductive layer 441 may have a monolayer or multilayer structure including at least a material of Ag, Pt, or W.

The second conductive layer 442 is disposed under the first conductive layer 441 and may be formed of a material including at least one of Ti, Ni, or Al. The second conductive layer 442 may have a greater electrical resistivity than at least a material of the materials constituting the first conductive layer 441. With this structure, the second conductive layer 442 can distribute electric current injected into the second conductive layer 442 such that the electric current can be uniformly supplied to a large area of the first conductive layer 441.

The third conductive layer 443 is disposed under the second conductive layer 442 and may have a monolayer or multilayer structure including at least a material of Au or In. The third conductive layer 443 may be formed of a material having a lower electrical resistivity than the second conductive layer 442, thereby allowing efficient conduction of large amounts of electric current.

The fourth conductive layer 444 is disposed under the third conductive layer 443 and may be formed of a material including at least one of Ti, Ni, or Al. The fourth conductive layer 444 may be formed of a material having a lower coefficient of thermal expansion than the third conductive layer 443 to prevent the electrodes from being delaminated and forming voids due to thermal deformation. The fifth conductive layer 445 is disposed under the fourth conductive layer 444 and may be formed of a material including Si. The fifth conductive layer 445 may be electrically connected to an external component, such as a circuit board, through contact therewith.

At least a layer of a current dispersion layer or an ohmic contact layer may be disposed between the semiconductor layer 401 and the second electrode 440. The current dispersion layer serves to disperse the electric current injected through the second electrode 440 such that the electric current uniformly passes across the entire region of the second window layer 430. For example, the current dispersion layer may be formed of an insulating material, such as SiO₂. The ohmic contact layer may be formed of a conductive material capable of forming ohmic contact with the second window layer 430.

The current dispersion layer and the ohmic contact layer may be disposed on the lower surface of the second window layer 430. For example, a plurality of current dispersion layers and a plurality of ohmic contact layers may be formed on the lower surface of the second window layer 430. Further, the current dispersion layers and the ohmic contact layers may be alternately arranged along the lower surface of the second window layer 430. Here, the first conductive layer 441 of the second electrode 440 may be formed to cover the plurality of current dispersion layers and the plurality of ohmic contact layers. Furthermore, when the plurality of current dispersion layers and the plurality of ohmic contact layers are spaced apart from each other, the first conductive layer 441 may be formed to fill a separation region therebetween and contact the second window layer 430.

The insulation layer 450 may cover the upper and side surfaces of the semiconductor layer 401. For example, the insulation layer 450 may be formed of an insulating material, such as SiO₂.

The insulation layer 450 may include an opening that exposes a region of the upper surface of the first window layer 410. Alternatively, the insulation layer 450 may include one first opening 451 and one or more second openings 452. In addition, the second openings 452 may extend from the first opening 451. A main electrode 471 of the second electrode 440 may be disposed in the first opening 451. The one or more second openings 452 connected to the first opening 451 may be disposed in one or more connection regions connected to the main electrode 471 of the second electrode 440.

In addition, the opening of the insulation layer 450 may have a structure that has a width gradually increasing from the upper surface of the first window layer 410 in an upward direction. That is, an inner side surface of the insulation layer 450, which defines the opening, may be an inclined surface. Furthermore, a third angle θ3 defined between the inner side surface of the insulation layer 450 defining the opening and a lower surface of the insulation layer 450 may be an acute angle. Accordingly, a separation distance between the insulation layer 450 and the first electrode 470 gradually increases in the upward direction, thereby preventing the side surface of the insulation layer 450 from being damaged by heat discharged from the first electrode 470.

The first ohmic electrode 460 may be formed on the upper surface of the first window layer 410 exposed by the openings in the insulation layer 450. The first ohmic electrode 460 may form ohmic contact with the first window layer 410. The first ohmic electrode 460 may be formed of the same material as the first ohmic electrode 81 (see FIG. 1, FIG. 3, and FIG. 4) according to the above embodiments.

Referring to FIG. 5, the first ohmic electrode 460 according to this embodiment may include a first region 461 and a second region 462 having different material compositions. Due to the different material compositions, the first region 461 and the second region 462 may have different coefficients of thermal expansion. A region of the first region 461 and the second region 462 may have a coefficient of thermal expansion between a coefficient of thermal expansion of the first electrode 470 and a coefficient of thermal expansion of the other region. For example, the coefficient of thermal expansion of the first region 461 may be between the coefficient of thermal expansion of the first electrode 470 and the coefficient of thermal expansion of the second region 462. Thus, the first region 461 of the first ohmic electrode 460 can prevent the first electrode 470 from being delaminated due to a difference in coefficient of thermal expansion between the first electrode 470 and the first ohmic electrode 460. Alternatively or conversely, the coefficient of thermal expansion of the second region 462 may be between the coefficient of thermal expansion of the first electrode 470 and the coefficient of thermal expansion of the first region 461. In this structure, the second region 462 can prevent the first electrode 470 from being delaminated by a difference in coefficient of thermal expansion between the first electrode 470 and the first ohmic electrode 460.

The first electrode 470 may be disposed on the upper surface of the first ohmic electrode 460. The first electrode 470 may be electrically connected to an external component, such as a circuit board, through contact therewith. Referring to FIG. 5, the first electrode 470 is formed to have an upper surface that is higher than the upper surface of the insulation layer 450, without being limited thereto.

Referring to FIG. 5, the structure of the semiconductor layer 401 according to this embodiment differs from the structure of the semiconductor layer according to the above embodiments. In the semiconductor layer 401 according to this embodiment, the first window layer 410 may include an electrode placement region 415 in which the first electrode 470 is disposed. More specifically, the first ohmic electrode 460 and the first electrode 470 may be disposed in the electrode placement region 415. The electrode placement region 415 has a structure that protrudes upwards, as compared with other regions of the first window layer 410. Therefore, on the upper surface of the first window layer 410, an upper surface of the electrode placement region 415 is placed higher than upper surfaces of the other regions. That is, the upper surface of the first window layer 410 has a concave region and a convex region, in which the convex region corresponds to the electrode placement region 415 in which the first electrode 470 is disposed. Since the electrode placement region 415 is the convex region, the electrode placement region 415 may include an upper surface and a side surface.

The electrode placement region 415 may include a main electrode placement region 411 in which the main electrode 471 of the first electrode 470 is disposed and extension electrode placement regions 412 in which extension electrodes 472 of the first electrode 470 are disposed. The electrode placement regions 415 have a structure corresponding to the structure of the first electrode 470, in which a plurality of extension electrode placement regions 412 extends from the main electrode placement region 411.

A width W3 of an upper region of the main electrode placement region 411 may be greater than a width W4 of a lower region thereof. This structure of the main electrode placement region 411 can increase a contact area between the first ohmic electrode 460 and the first window layer 410, as compared with a structure of the main electrode placement region 411 in which the upper region of the main electrode placement region 411 has the same width as the lower region thereof. Accordingly, the light emitting device 400 according to this embodiment may have a sufficient contact area between the first ohmic electrode 460 and the first window layer 410 through the main electrode placement region 411.

According to this embodiment, at least a region of the main electrode placement region 411 or the extension electrode placement regions 412 may have at least an acute angle between upper and side surfaces thereof in a vertically cut cross-section. For example, the main electrode placement region 411 may have a first angle θ1 defined between the upper surface and one side surface thereof, which is an acute angle, and a second angle θ2 defined between the upper surface and the other side surface thereof, which is a right angle or an obtuse angle. With this structure, the main electrode placement region 411 can secure a large area in which the first electrode 470 is disposed, thereby enabling reduction in electrical resistance. Referring to FIG. 5, in this embodiment, the second angle θ2 is an obtuse angle.

In the light emitting device 400 according to this embodiment, at least a side surface of the electrode placement region 415 may have the same inclination direction as one inner side surface of the insulation layer 450. More specifically, at least a side surface of the main electrode placement region 411 may have the same inclination direction as one inner side surface of the insulation layer 450 defining the first opening 451. Here, the one inner side surface of the insulation layer 450 is a region disposed adjacent to one side surface of the main electrode placement region 411 in an upward direction of the one side surface of the main electrode placement region 411, among the inner sides of the insulation layer 450 on the main electrode placement region 411.

Referring to FIG. 5, one side surface of the main electrode placement region 411 and one inner side surface of the insulation layer 450 defining the first opening 451 have the same inclination direction, and the other side surface of the main electrode placement region 411 and the other inner side surface of the insulation layer 450 defining the first opening 451 have different inclination directions. However, it should be understood that the structure of the light emitting device 400 according to the present invention is not limited thereto and all of the side surfaces of the main electrode placement region 411 and all of the inner side surfaces of the insulation layer 450 defining the first opening 451 may have the same inclination direction.

According to this embodiment, the semiconductor layer 401 may include a mesa M having an upper surface with a smaller cross-sectional area or narrower width than a lower surface thereof. That is, a region or the entire region of a periphery of an upper surface of the semiconductor layer 401 is located in an upper region inside a periphery of a lower surface of the semiconductor layer 401. Here, the upper surface of the semiconductor layer 401 corresponds to the upper surface of the first window layer 410 and the lower surface of the semiconductor layer 401 corresponds to the lower surface of the second window layer 430.

Further, the semiconductor layer has a structure in which a cross-sectional area or width of the upper surface of the first window layer 410 is greater than a cross-sectional area or width of the lower surface of the first window layer 410. Alternatively, the cross-sectional area of the upper surface of the first window layer 410 or the maximum width of the first window layer 410 may be greater than the cross-sectional area of the upper surface of the second window layer 430 or the maximum width of the second window layer 430. Alternatively, the cross-sectional area of the upper surface of the first window layer 410 or the maximum width of the first window layer 410 may be greater than the cross-sectional area or maximum width of the active layer 420.

According to this embodiment, at least a side surface of the semiconductor layer 401 may include an inwardly concave region. Referring to FIG. 5, although the upper surface of the first window layer 410 has a narrower width than the upper surface of the second window layer 430, the width of the upper surface of the first window layer 410 is greater than the width of the lower surface of the first window layer 410 or the width of the active layer 420. That is, the semiconductor layer 401 has a structure in which the mesa M is located in an upper region inside the periphery of the lower surface of the second window layer 430 and the periphery of the upper surface of the semiconductor layer 401 protrudes most outwardly. Thus, the semiconductor layer 401 according to this embodiment has a structure in which the width of the semiconductor layer 401 gradually decreases from the lower surface thereof and then gradually increases again in the upward direction. Accordingly, the semiconductor layer 401 may have a fourth angle θ4 between the upper surface and the side surface thereof, which is an acute angle. Although FIG. 5 shows the semiconductor layer 401 including concave regions on both side surfaces thereof, it should be understood that the semiconductor layer 401 may include a concave region only on one side surface thereof.

According to this embodiment, the side surfaces of the first window layer 410 are curved such that the upper surface of the first window layer 410 has a larger area than the lower surface of the first window layer 410. Such a structure of the first window layer 410 can increase an area on which the electrodes are disposed on the semiconductor layer 401. Thus, the light emitting device 400 according to this embodiment can increase the electrode placement region 415, thereby increasing the area of the first electrode 470.

FIG. 6 is an enlarged view of Region A of FIG. 5. Referring to FIG. 6, the region including the periphery of the first window layer 410 is located above the second window layer 430 outside the active layer 420.

According to this embodiment, a region of the first window layer 410 protrudes outwards beyond other regions of the first window layer 410. An air layer and the insulation layer 450 are present between a protruding region of the first window layer 410 and the second window layer 430 disposed below the first window layer 410. Therefore, light L emitted from the protruding region of the first window layer 410 and directed in a downward direction can be reflected at the interfaces of the air layer and the insulation layer 450, which have different indexes of refraction, to travel in the upward direction of the light emitting device 400. Furthermore, even when the light L emitted from the protruding region of the first window layer 410 and directed in the downward direction passes through the insulation layer 450, the light L can be reflected at the interface between the insulation layer 450 and the second window layer 430, which have different indexes of refraction, to travel in the upward direction of the light emitting device 400. Accordingly, as the protruding region of the first window layer 410 is located above a region of the second window layer 430, the protruding region of the first window layer 410 can reflect the light L emitted from the first window layer 410 and directed in the downward direction to travel in the upward direction, thereby improving light extraction efficiency of the light emitting device 400.

Referring to FIG. 6, the semiconductor layer 401 may further include side irregularities 421 formed on the side surfaces thereof. The side irregularities 421 may be located between the upper surface of the first window layer 410 and the lower surface of the second window layer 430. For example, the side irregularities 421 may be formed on the side surfaces of the active layer 420. The side irregularities 421 may be located inside an outer side surface of the first window layer 410. The side irregularities 421 may be formed inside the first window layer 410, thereby preventing damage from the outside while increasing a lateral light extraction area of the light emitting device 400.

Furthermore, according to this embodiment, the upper surface of the semiconductor layer 401 may include a region formed with irregularities. Referring to FIG. 5, the first window layer 410 is formed on the upper surface thereof with the irregularities in a region excluding the electrode placement region 415. Further, depending on the irregularities formed on the upper surface of the first window layer 410, the insulation layer 450 formed thereon may also be formed on an upper surface thereof with irregularities. By the irregularities formed on the upper surface of the semiconductor layer 401 and the upper surface of the insulation layer 450, a light extraction area can be increased on the upper surface of the semiconductor layer 401, thereby improving light extraction efficiency on the upper surface of the semiconductor layer 401.

Furthermore, according to this embodiment, the semiconductor layer 401 has a plurality of irregularities formed on the side surface thereof. By the plurality of irregularities formed on the side surface of the semiconductor layer 401, the light extraction area on the side surface of the semiconductor layer 401 can be increased. Therefore, the light emitting device 400 according to this embodiment can have improved light extraction efficiency on the side surfaces of the semiconductor layer 401.

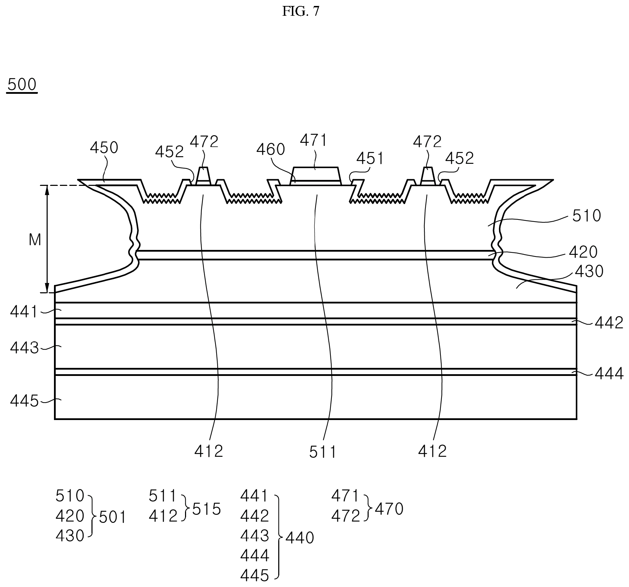

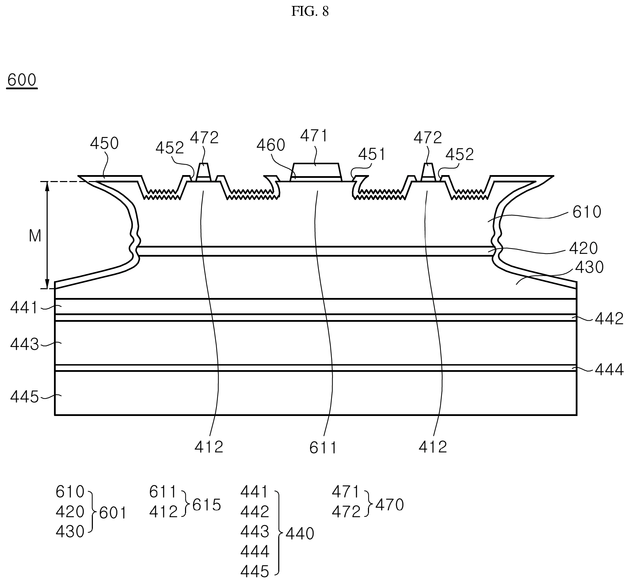

FIG. 7 is a schematic cross-sectional view of a light emitting device 500 according to a fifth embodiment of the present invention and FIG. 8 is a schematic cross-sectional view of a light emitting device 600 according to a sixth embodiment of the present invention.

The light emitting devices 500, 600 according to the fifth and sixth embodiments have the same structure as the light emitting device 400 according to the fourth embodiment shown in FIG. 5 except for the structures of the first window layers 510, 610 of the semiconductor layers 501, 601. More specifically, the main electrode regions 511, 611 of the light emitting devices 500, 600 according to the fifth and sixth embodiments have different structures from the main electrode region 411 (see FIG. 5) according to the fourth embodiment. The following description of the light emitting devices 500, 600 according to the fifth and sixth embodiments will focus on the main electrode placement regions 511, 611.

Each of the light emitting devices 500, 600 according to the fifth and sixth embodiments may include a first ohmic electrode 460 and an electrode placement region 515, 615 in which the first electrode 470 is disposed. In addition, the electrode placement region 515, 615 may include a main electrode placement region 511, 611 in which the main electrode 471 of the first electrode 470 is disposed, and extension electrode placement regions 412 in which the extension electrodes 472 of the first electrode 470 are disposed. Referring to FIG. 7 and FIG. 8, both side surfaces of the main electrode placement region 511, 611 may be slanted in opposite directions or may have opposite inclination directions. The main electrode placement region 511, 611 may have a width and a cross-sectional area gradually increasing in the upward direction.

According to the fifth and sixth embodiments, the inclination directions of at least a side surface of the main electrode placement region 511, 611 and the electrode placement region 415 may be the same as the inclination direction of one inner side surface of the insulation layer 450. More specifically, both side surfaces of the main electrode placement region 511, 611 may have the same inclination direction as both inner side surfaces of the insulation layer 450 located in an upper region of the main electrode placement region. Referring to FIG. 7 and FIG. 8, one side surface of the main electrode placement region 511, 611 has the same inclination direction as one inner side surface of the insulation layer 450 located in an upper region thereof and closest thereto. Furthermore, the other side surface of the main electrode placement region 511, 611 has the same inclination direction as the other inner side surface of the insulation layer 450 located in the upper region thereof and closest thereto.

Furthermore, the main electrode placement region 511, 611 may have an inclined flat or curved side surface. In the fourth and fifth embodiments shown in FIG. 5 and FIG. 7, the side surface of the main electrode placement region 411, 511 is flat. Furthermore, in the sixth embodiment of FIG. 8, the side surface of the main electrode placement region 611 is a curved surface that is concave in an inward direction.

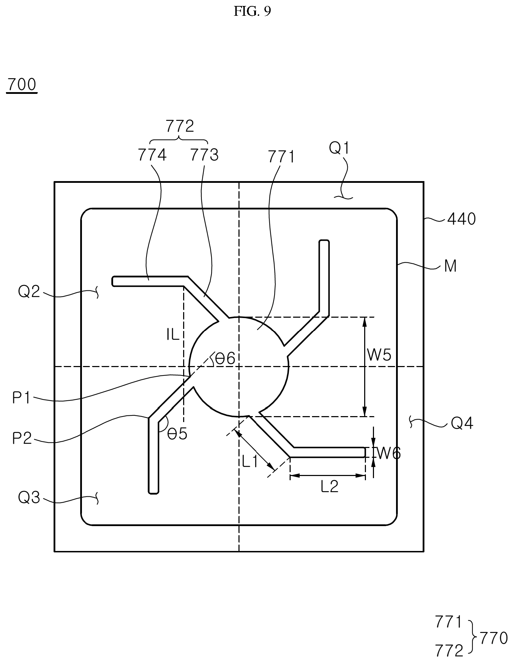

FIG. 9 to FIG. 11 are top views of light emitting devices, illustrating embodiments of a first electrode pattern according to the present invention.

FIG. 9 is a top view of the light emitting device according to the present invention, illustrating a first embodiment of a first electrode pattern.

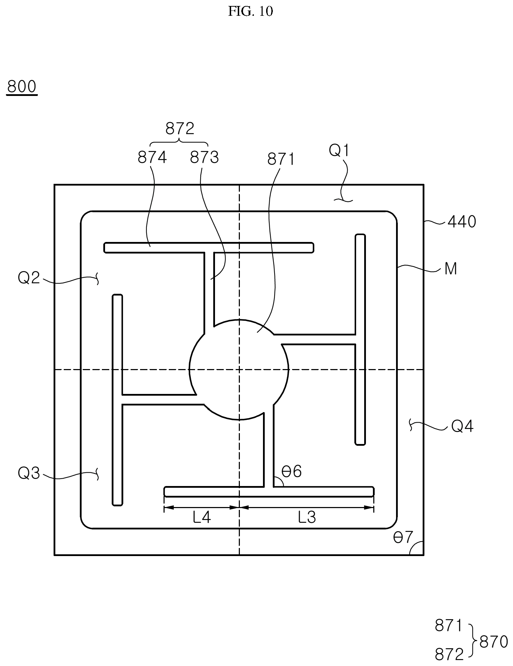

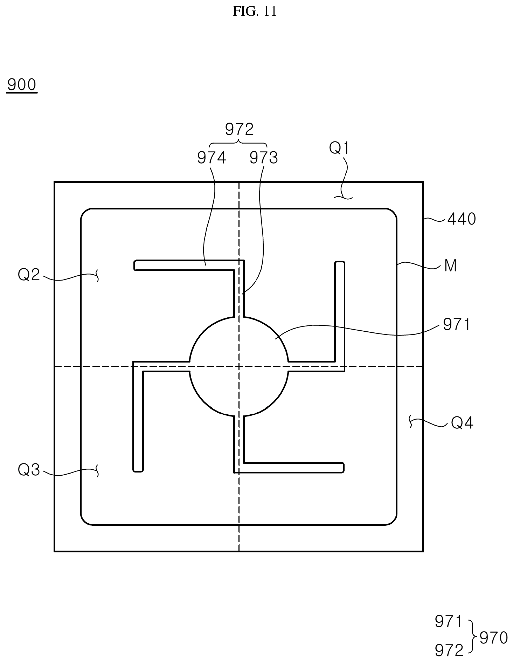

Referring to FIG. 9, the light emitting device 700 may include a first electrode 770 electrically connected to the first window layer 31. Unlike the first electrode shown in FIG. 1, FIG. 3, and FIG. 4, the first electrode 770 may be disposed opposite to the second electrode 440 electrically connected to the second window layer with reference to the active layer. The structure of the first electrode 770 of the light emitting device 700 shown in FIG. 9 may be applied to the light emitting devices 400, 500, 600 shown in FIG. 5, FIG. 7, and FIG. 8. The structures of the first electrodes 870, 970 of the light emitting devices 800, 900 shown in FIG. 10 and FIG. 11, which will be described below, may also be applied to the light emitting devices 400, 500, 600 shown in FIG. 5, FIG. 7, and FIG. 8. For the structure of the second window layer and the second electrode 440 shown in FIG. 9 to FIG. 11, refer to the description of FIG. 5, FIG. 7, and FIG. 8.

According to this embodiment, the first electrode 770 may include a curved main electrode 771. For example, the main electrode 771 of the first electrode 770 may have a circular shape. The first electrode 770 may further include extension electrodes 772 that extend from the main electrode 771 to be close to an outer periphery of the light emitting device 700. A width W6 of the extension electrodes 772 may be narrower than a width W5 of the main electrode 771 and a length L1+L2 of each of the extension electrodes 772 may be greater than the width W5 of the main electrode 771.

Referring to the top view of FIG. 9, the light emitting device 770 may include first to fourth quadrants Q1, Q2, Q3, and Q4. A plurality of extension electrodes 772 may be formed and may be disposed in the quadrants Q1, Q2, Q3, Q4, respectively. The plurality of extension electrodes 772 may be have a rotationally symmetrical structure with respect to the center of the top view or the center of the main electrode 771. Thus, when light is emitted, the light may be reflected from side surfaces of the rotationally symmetrical structure of the extension electrodes 772 and focused in the upward direction of the light emitting device 700.

Each of the extension electrodes 772 of the first electrode 770 may include a first extension region 773 extending from the main electrode 771 and a second extension region 774 extending from the first extension region 773.

The first extension region 773 and the second extension region 774 of the extension electrode 772 may define a first angle θ5 therebetween. The first angle θ5 defined between the first extension region 773 and the second extension region 774 may be greater than or equal to 85 degrees and less than 180 degrees. The light emitting device 700 according to this embodiment may be formed such that the first extension region 773 and the second extension region 774 of the first electrode 770 have the first angle θ5 therebetween to allow uniform distribution of electrical current on one surface of the light emitting device 700. Here, the one surface of the light emitting device 700 refers to a surface on which the first electrode 770 is formed.

A point P1 at which the first extension region 773 of the extension electrode 772 meets the main electrode 771 may be disposed close to a boundary of the corresponding quadrant. A second angle θ6 defined between the first extension region 773 of the extension electrode 770 or an imaginary extension of the first extension region 773 and the boundary of the quadrant adjacent to the first extension region 773 may be greater than or equal to 0 degrees and less than or equal to 60 degrees.

The extension electrode 772 may include a second point P2 at which the first extension region 773 is connected to the second extension region 774. The second extension region 774 of the extension electrode 772 may be disposed parallel to a side surface of the light emitting device 700. Here, the side surface of the light emitting device 770 parallel to the second extension region 774 refers to a surface most adjacent to a distal end of the first extension region 773 connected to the second extension region 774. An imaginary line IL parallel to the side surface of the light emitting device 700 at the point where the first extension region 773 of the extension electrode 772 is connected to the second extension region 774 thereof (at the second point P2) may intersect the first extension region 773 of the extension electrode 772 adjacent thereto. Here, the side surface of the light emitting device 700 parallel to the imaginary line IL refers to a surface located in a direction in which a distal end of the second extension region 774 faces.

Although not shown in the drawings, at least a wire may be connected to the first electrode 770 and may pass over an upper surface of at least a quadrant.

FIG. 10 is a top view of the light emitting device according to the present invention, illustrating a second embodiment of the first electrode pattern. The following description of the configuration of FIG. 10 will focus only on different features excluding the same features shown in FIG. 9.

The light emitting device 800 according to this embodiment may include a first electrode 870 that includes a main electrode 871 and extension electrodes 872. In addition, each of the extension electrodes 872 may include a first extension electrode 873 extending from the main electrode 871 and a second extension electrode 874 extending from the first extension electrode 873. Referring to FIG. 10, the first extension region 873 of the extension electrode 872 may be parallel to a side surface of the light emitting device 800 and to the boundary of the quadrant. The second extension region 874 extending from the first extension region 873 of the extension electrode 872 may be formed perpendicular to the first extension region 873. The first extension region 873 may be electrically connected to the second extension region 874 between two distal ends of the second extension region 874. The second extension region 874 may be formed in at least a quadrant and may extend to another quadrant adjacent thereto. A length L3 of the second extension region 874 disposed in a quadrant may be greater than a length L4 of the second extension region 874 disposed in the other quadrant adjacent thereto.

According to this embodiment, an angle θ6 defined between the first extension region 873 and the second extension region 874 of the extension electrode 872 may be substantially similar to an angle θ7 defined between two side surfaces forming the corner of the light emitting device 800.

FIG. 11 is a top view of the light emitting device according to the present invention, illustrating a third embodiment of the first electrode pattern. Redundant description of the above embodiments will be omitted.

The light emitting device 900 according to this embodiment may include a first electrode 970 that includes a main electrode 971 and extension electrodes 972. Each of the extension electrodes 972 may include a first extension electrode 973 extending from the main electrode 971 and a second extension electrode 974 extending from the first extension electrode 973. Referring to FIG. 11, the first extension regions 973 of the extension electrodes 972 facing each other may be disposed on the same line with reference to the main electrode 971 of the first electrode 970. In addition, the first extension regions 973 of the extension electrodes 972 may be disposed at the boundaries of the quadrants.

A distal end of the second extension region 974 of the extension electrode 972 may adjoin an imaginary line IL extending from the distal end of the second extension region 974 of the extension electrode 972 adjacent to the extension electrode 972 or may be disposed inside the imaginary line IL so as not to intersect the same.

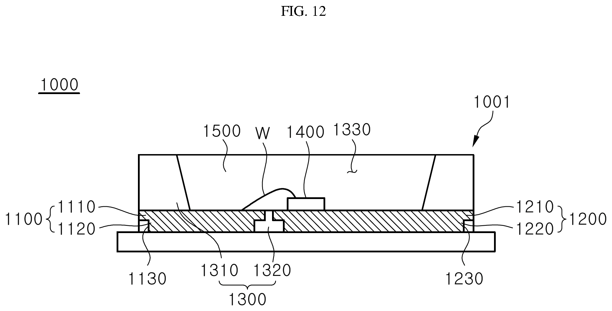

FIG. 12 is a view of a light emitting apparatus employing a light emitting device according to an embodiment of the present invention.

Referring to FIG. 12, the light emitting module 1000 may include a circuit board 1600 and a light emitting package 1001 disposed on the circuit board 1600. The light emitting package 1001 includes a first lead 1100, a second lead 1200, a body 1300, and a light emitting device 1400. The light emitting device 1400 may be any one of the light emitting devices according to the embodiments described above. When the light emitting module 1000 includes a plurality of light emitting packages 1001, the light emitting packages 1001 may include at least a type of light emitting device among the light emitting devices according to the embodiments described above. That is, the light emitting module 1000 may include a plurality of light emitting devices that belong to a type of light emitting device among the light emitting devices according to the embodiments described above or may include at least two types of light emitting devices thereamong. The light emitting package 1001 may further include a molding layer 1500.

The first lead 1100 and the second lead 1200 may be spaced apart from each other and a separation space between the first lead 1100 and the second lead 1200 may be filled with a base 1320 of the body 1300.

The first lead 1100 may include a first-1 lead 1110 and a first-2 lead 1120, and the second lead 1200 may include a second-1 lead 1210 and a second-2 lead 1220. The first-1 lead 1110 and the first-2 lead 1120 may be integrally formed with each other and the second-1 lead 1210 and the second-2 lead 1220 may also be integrally formed with each other. The first lead 1100 and the second lead 1200 may include a material having high electrical and thermal conductivity. For example, the first lead 1100 and the second lead 1200 may include a metal or a metal alloy.

The separation space between the first lead 1100 and the second lead 1200 may be bent at least once.

The first lead 1110 is located on the second lead 1120. The first-2 lead 1120 has a smaller area than the first-1 lead 1110 and may be located within a region occupied by the first-1 lead 1110. Thus, in plan view, among the first lead 1110 and the second lead 1120, only the first lead 1110 is exposed on an upper surface of the light emitting module 1000. Further, due to a difference in area between the first lead 1110 and the second lead 1120, a multi-stage structure 1130 may be formed on a side surface of the first lead 1100. A space created by the multi-stage structure 1130 may be filled with the base 1320 such that the first lead 1100 can be more firmly secured to the body 1300.

The second-1 lead 1210 is located on the second-2 lead 1220. The second-2 lead 1220 may have a smaller area than the second-1 lead 1210 and may be located within a region occupied by the second-1 lead 1210. Thus, in plan view, among the second lead 1210 and the second lead 1220, only the second lead 1210 is exposed on the upper surface of the light emitting module 1000. Further, due to a difference in area between the second lead 1210 and the second lead 1220, a multi-stage structure 1230 may be formed on a side surface of the second lead 1200. A space created by the multi-stage structure 1230 may be filled with the base 1320 such that the second lead 1200 can be more firmly secured to the body 1300.

The body 1300 may include a reflector 1310 and the base 1320.

The base 1320 may surround at least a region of the side surfaces of the first lead 1100 and the second lead 1200 and may fill the space between the first lead 1100 and the second lead 1200. As the base 1320 fills the space between the first lead 1100 and the second lead 1200, upper and lower surfaces of the first lead 1100 and the second lead 1200 may be exposed. Accordingly, the upper surface of the base 1320 may be substantially coplanar with the upper surfaces of the first and second leads 1100, 1200 and the lower surface of the base 1320 may be substantially coplanar with the lower surfaces of the first and second leads 1100, 1200. However, it should be understood that the present invention is not limited thereto.

A surface of the first-1 lead 1110 and a surface of the first-2 lead 1120 may be exposed on a side surface of the base 1320. The surface of the first-1 lead 1110 and the surface of the first-2 lead 1120 may be formed parallel to the side surfaces of the base 1320. Alternatively, in another embodiment, the surface of the first-1 lead 1110 and the surface of the first-2 lead 1120 may protrude outwards beyond the side surface of the base 1320. Regardless of whether the light emitting package 1001 is mounted on the circuit board 1600, electricity may be applied to the light emitting package 1001 through the surface of the first-1 lead 1110 and the surface of the first-2 lead 1120 to turn on the light emitting package 1001 or to determine whether the light emitting package 1001 is defective.

The reflector 1310 may be disposed in an upper region of the leads 1100, 1200. In addition, the reflector 1310 may be disposed along an outer periphery of the light emitting package 1001 that includes the base 1320 and the leads 1100, 1200. Further, the reflector 1310 may be formed with a cavity 1330 that exposes a region of the upper surface of the first lead 1100, a region of the upper surface of the second lead 1200, and the upper surface of the base 1320.

The reflector 1310 may reflect light emitted from the light emitting device 1400 in the upward direction. The reflector 1310 may have an inclined inner wall to improve light reflection efficiency.

The reflector 1310 may include a ceramic or polymer material. For example, the reflector 1310 may include a silicone, polyamide, or epoxy resin. In addition, the reflector 3200 may further include fillers, such as TiO₂.

The light emitting device 1400 may be disposed on at least a lead of the first lead 1100 and the second lead 1200 in the cavity 1330 of the reflector 1310 and may be electrically connected to the first lead 1100 and the second lead 1200. Although the light emitting module 1000 is illustrated as including a single light emitting device 1400 in FIG. 12, it should be understood that the light emitting module may include a plurality of light emitting devices 1400.

Referring to FIG. 12, the light emitting device 1400 may be electrically connected to the first lead 1000 by the wire W. However, depending on the structure, the light emitting device 1400 may also be disposed on the first lead 1100 and the second lead 1200 to be electrically connected to the first lead 1100 and the second lead 1200 through a conductive material.

The light emitting package 1001 including the light emitting device 1400, the leads 1100, 1200, and the body 1300 may be disposed on the circuit board 1600.

The circuit board 1600 may include electrodes including conductive materials to be electrically connected to the light emitting package 1001 and thereby to the light emitting device 1400.

The light emitting module 1000 may include an IC circuit or an IC driver for driving or controlling the light emitting package 1001. The IC circuitry or the IC driver may be disposed within the circuit board 1600 or may be separately configured to be electrically connected to the circuit board 1600. Alternatively, the light emitting package 1001 may include the IC circuit or the IC driver and the light emitting module 1000 may be driven or controlled through the IC circuit or the IC driver included in the light emitting package 1001. In addition, the IC circuit or the IC driver may be covered together with the plurality of light emitting devices 1400 by the molding layer 1500. In this structure, since the IC circuit or the IC driver can be handled together with the plurality of light emitting devices 1400 in a package, the light emitting module 1000 can be easily applied to a product.

In light emitting package 1001, a thickness from the upper surface of the first lead 1100, the second lead 1200, the IC circuit, or the IC driver to a light exit surface of the molding layer 1500 may be different from a thickness from the upper surface of light emitting device 1400 to the light exit surface of the molding layer 1500. The light emitting device 1400 and components, such as IC circuits or IC drivers, may have different thicknesses. In this structure, the molding layer 1500 may cover the components having different thicknesses such that the entire region of the light exit surface is located at the same height. Here, in this embodiment, the light exit surface may correspond to an upper surface of the molding layer 1500.

The light emitting devices and the light emitting modules according to the embodiments of the invention described above may be applied to a light emitting system. According to an embodiment, the light emitting system may include a plurality of light emitting modules arranged in each zone. Further, in the light emitting system, various light emitting modules may be freely arranged in each zone, as needed.

By way of example, when the light emitting system is configured to realize a single color, the light emitting system may include a plurality of light emitting modules configured to emit light of similar peak wavelengths with a deviation of the peak wavelengths of 5 nm or less. Alternatively, when the light emitting system is configured to realize a full range of colors, the light emitting system may include a plurality of light emitting modules configured to emit light of different colors.

According to an embodiment of the present invention, the light emitting system may be applied to a display for automobiles. In particular, the light emitting system may be applied to a rear lamp for automobiles, such as a brake lamp and the like, and to a charging signal lamp in an electric vehicle.

According to an embodiment of the present invention, the light emitting system may be configured to implement a string of characters (English, figures, Korean characters, and the like). By way of example, the light emitting system may be configured to realize a first character in a first region, a second character in a second region, a third character in a third region, and a fourth character in a fourth region in a display apparatus. In this way, the light emitting system applied to the display apparatus can send various data to the outside.

Furthermore, according to an embodiment of the present invention, the light emitting system may be realized through a subscription service. For example, the light emitting system may be realized on a display apparatus or lighting when a user subscribes to a service that makes certain colors, certain characters, certain shapes, and the like available to the user.

In another embodiment of the present invention, the light emitting device may be provided to a plant lighting module to assist in growth of plants. The plant lighting module may include a circuit board and a plurality of light emitting devices mounted on the circuit board. The plurality of light emitting devices may be of at least a type among the above light emitting devices according to the embodiments described above.

Although some embodiments have been described herein with reference to the accompanying drawings, it should be understood that various modifications and changes can be made by those skilled in the art or by a person having ordinary knowledge in the art without departing from the spirit and scope of the present invention defined by the claims and equivalents thereto.

Therefore, the scope of the present invention should be defined by the appended claims and equivalents thereto rather than by the detailed description of the invention.

## Claims

1. A light emitting device comprising:
a semiconductor layer comprising a first window layer doped with a first dopant, a second window layer doped with a second dopant, and an active layer disposed between the first window layer and the second window layer;
an insulation layer covering the semiconductor layer and comprising an opening exposing a region of at least a window layer of the first window layer or the second window layer;
a first electrode electrically connected to the first window layer; and
a second electrode electrically connected to the second window layer,
wherein the semiconductor layer comprises side irregularities formed on a side surface between an upper surface of the first window layer and a lower surface of the second window layer.

2. The light emitting device according to claim 1, wherein the side irregularities are formed on a side surface of the active layer.

3. The light emitting device according to claim 1, wherein the semiconductor layer comprises a mesa having a structure gradually decreasing and then increasing again in width or cross-sectional area in an upward direction,
an upper surface of the semiconductor layer has a smaller cross-sectional area or width than a lower surface of the semiconductor layer, and
the semiconductor layer comprises a protruding region formed on the upper surface thereof and protruding outwards beyond a side surface of the mesa.

4. The light emitting device according to claim 1, wherein
the first window layer protrudes in a direction in which the first electrode is disposed and comprises an electrode placement region in which the first electrode is disposed, and
at least a region of the electrode placement region has a greater width in an upper region thereof than in a lower region thereof.

5. The light emitting device according to claim 1, further comprising:
a first ohmic electrode disposed between the first electrode and the first window layer, and comprising a first region and a second region having different coefficients of thermal expansion,
the first region having a coefficient of thermal expansion between a coefficient of thermal expansion of the first electrode and a coefficient of thermal expansion of the second region.

6. The light emitting device according to claim 1, wherein the light guide layer includes a plurality of layers having a refractive index difference of 0.05 to 0.3 disposed inside the semiconductor layer.

7. The light emitting device according to claim 1, further comprising a first cladding layer disposed between the first window layer and the active layer,
wherein the first cladding layer includes an n-InₓAl₍₁₋ₓ₎P layer, where x has a value in a range of 0.4≤x≤0.6.

8. The light emitting device according to claim 1, further comprising a second cladding layer disposed between the active layer and the second window layer,
wherein the second cladding layer includes a p-InₓAl₍₁₋ₓ₎P layer, where x has a value in a range of 0.4≤x≤0.6.

9. The light emitting device according to claim 1, further comprising:
a first electron regulation layer disposed between the first window layer and the active layer; and
a first hole regulation layer disposed between the active layer and the second window layer,
wherein a thickness of the first hole regulation layer is 1 to 2 times that of the first electron regulation layer.

10. The light emitting device according to claim 9, wherein the first hole regulation layer has a thickness in a range of 300nm to 500 nm.

11. The light emitting device according to claim 1, wherein the second window layer includes a GaP layer, and has a thickness of 500 nm to 10,000 nm.

12. The light emitting device according to claim 1, further comprising a contact layer disposed between the second window layer and a second ohmic layer,
wherein the contact layer has an average doping level of about 1e19 atoms/cm³ or more, and has a thickness of less than 100 nm.

13. The light emitting device according to claim 1, wherein the second electrode is formed in an inner region of the opening of the insulation layer to be spaced apart from an inner side surface of the opening of the insulation layer.

14. The light emitting device according to claim 1, wherein the first electrode includes a main electrode and extension electrodes, each of which includes a first extension electrode extending from the main electrode and a second extension electrode extending from the first extension electrode, and
wherein a first angle defined between a first extension electrode and the second extension electrode is substantially similar to a second angle defined between two side surfaces forming corner of the light emitting device.

15. The light emitting module, comprising:
a circuit board; and
a light emitting package,
wherein the light emitting package includes a first lead, a second lead, a body, and a light emitting device according to any of claims 1-14,
wherein a multi-stage structure is formed on a side surface of the first lead, and
wherein a space created by the multi-stage structure is filled with a base such that the first lead is firmly secured to the body.
